# EUROPEAN PATENT APPLICATION

(11) **EP 4 822 988 A1**
(43) Date of publication of application: **14.10.2026**
(21) Application number: 26170183.3
(22) Date of filing: 01.04.2026
(51) Int. Cl.: H03F 3/08, H03F 3/45

(54) **DIELECTRIC ABSORPTION MITIGATION IN PHOTODIODE SENSING CIRCUITS**

(30) Priority: 09.04.2025 US 202519174024
(71) Applicant: Avago Technologies International Sales Pte. Limited, Singapore 768923 (SG)
(72) Inventor: Agarwal, Rishi Chandra, Irvine, CA, 92618 (US); Astgimath, Santosh, Edinburgh, EH11 3LS (GB); Chandrasekhar, Vinay, Irvine, CA, 92602 (US); Cheung, Yee Ling, Irvine, CA, 92602 (US); Damaraju, Naga Radha Krishna, Irvine, CA, 92620 (US); Findlater, Keith Michael, Edinburgh, EH10 4SZ (GB); Lu, Junjie, Irvine, CA, 92620 (US); Maughan, Steven Ashley, Edinburgh, EH12 8WW (GB); McCorkell, Graham John, West Lothian, EH49 6AS (GB); Mitev, Mihail Dimitrov, Edinburgh, EH10 4NB (GB); Neil, David John, Edinburgh, EH16 6TU (GB); Purcell, Matthew David, Edinburgh, EH12 7LZ (GB); Song, Jungwoo, Irvine, CA, 92620 (US); Stubbs, Dale George Frederick, Linlithgow, EH49 7DB (GB); van Engelen, Josephus Adrianus, Aliso Viejo, CA, 92656 (US)
(74) Representative: Grünecker Patent- und Rechtsanwälte PartG mbB

(57) **Abstract**

The present disclosure provides a system for mitigating dielectric absorption in a photodiode sensing circuit. The system includes a photodetector array comprising a plurality of photodiode and a sensing circuit coupled to the photodetector array. The sensing circuit comprises a switch matrix configured to selectively route signals from the photodiode, an amplifier array comprising at least one transimpedance amplifier, a reference generator configured to apply a reference voltage to at least one photodiode, and a timing generator configured to control switching between sequence of states of the system, including a sleep state, a pre-charge state, and an active state. The system enables effective mitigation of dielectric absorption by implementing a pre-charge state before transitioning to an active sensing state.

## Description

### BACKGROUND

The present disclosure relates to photodiode sensing circuits, and more particularly to techniques for mitigating dielectric absorption in capacitors used in sensing circuits associated with photodetector arrays.

Photodiode sensing circuits are widely used in various applications, including light detection, imaging, and optical communication. These systems typically consist of an array of photodiode that convert light into electrical signals, along with associated circuitry for processing and analyzing the generated signals.

### BRIEF DESCRIPTION OF DRAWINGS

The accompanying drawings, which form part of this specification, depict examples of the disclosure and, along with the description, illustrate the underlying principles of these examples. The detailed description is provided with reference to the accompanying figures. In the figures, the leading digit(s) of each reference number correspond to the figure where the reference number first appears. The figures are not drawn to scale, and certain proportions or elements may be exaggerated in some figures to enhance the clarity of specific features.

Non-limiting and non-exhaustive examples are described with reference to the following figures.
FIG. 1 illustrates an exemplary system, in accordance with one or more embodiments of the disclosure.
FIG. 2 illustrates exemplary switches, in accordance with one or more embodiments of the disclosure.
FIG. 3 illustrates an exemplary sequence of states, in accordance with one or more embodiments of the disclosure.

In the drawings, like reference symbols and numerals indicate the same or similar components. Like elements in the various figures are denoted by like reference symbols and numerals for consistency. Identical or similar items across different figures are indicated by the same reference numbers. Unless otherwise indicated, like elements and method steps are referred to with like reference numerals.

### DETAILED DESCRIPTION OF THE INVENTION

The following describes technical solutions in this specification with reference to the accompanying drawings. It should be recognized, however, that such description is not intended as a limitation on the scope of the present disclosure. Rather, the description also encompasses combinations and modifications to those exemplary aspects described herein. Exemplary embodiments are described in detail with reference to the accompanying drawings.

In many photodiode sensing applications, accurate and precise measurements are desired. However, several factors can affect the performance of these systems, including noise, interference, and various electrical phenomena that occur within the circuit components.

One such phenomenon affecting capacitors within the sensing circuitry is dielectric absorption. This occurs when a capacitor retains a residual charge even after being fully discharged, potentially resulting in prolonged settling times and inaccuracies in measurements. Additionally, dielectric absorption may cause variations in the stored charge of a capacitor even when the applied voltage remains constant. This effect is especially problematic in high-precision analog circuits, such as those employed in photodiode sensing applications, where signal accuracy and stability are critical.

Efforts to mitigate the effects of dielectric absorption have been ongoing in the field of electronic circuit design. Various techniques have been explored, including the use of specialized capacitor materials, circuit topologies, and signal processing methods. However, challenges remain in effectively addressing dielectric absorption while maintaining overall system performance and efficiency.

Another consideration in photodiode sensing circuits is power management. Many applications require low power consumption, especially in portable or battery-operated devices. Balancing the need for accurate measurements with power efficiency often involves careful design of power distribution networks and the implementation of power-saving modes.

Signal routing and switching within photodiode sensing circuits present additional challenges. The ability to selectively activate and read out individual photodiode within an array, while minimizing crosstalk and maintaining signal integrity, is often desired. This typically involves the use of switch matrices and multiplexing schemes, which must be carefully designed to avoid introducing additional noise or distortions into the system.

As the demand for higher performance and more compact photodiode sensing circuits continues to grow, there is an ongoing need for improved techniques to address these and other challenges in the field. Advancements in circuit design, materials science, and signal processing may contribute to the development of more accurate, efficient, and versatile photodiode sensing circuits for a wide range of applications.

Accordingly, there is a need in the art for an improved photodiode sensing circuit.

The present disclosure relates to techniques for mitigating dielectric absorption in capacitors used in sensing circuits. In particular, the disclosed techniques may be applied to capacitors associated with transimpedance amplifiers and other sensing circuitry.

The techniques described herein provide methods and apparatus for pre-charging capacitors to mitigate dielectric absorption. By applying a reference voltage (Vref) to capacitors for a period of time before measurement or signal amplification, the dielectric absorption may be allowed to settle. This pre-charging approach may improve settling time and accuracy in sensing circuits.

In some implementations, the disclosed techniques may be applied to both on-chip and off-chip capacitors associated with sensing circuitry. The pre-charging may be performed using dedicated pre-charge buffers and switching arrangements to route signals appropriately. Timing sequences may be employed to coordinate pre-charging and measurement phases.

While particularly applicable to transimpedance amplifier circuits used with photodiode, the techniques described herein may also be useful in other types of sensing and measurement circuits where capacitor dielectric absorption can impact performance. The disclosed approaches aim to improve overall sensing accuracy and speed in such applications.

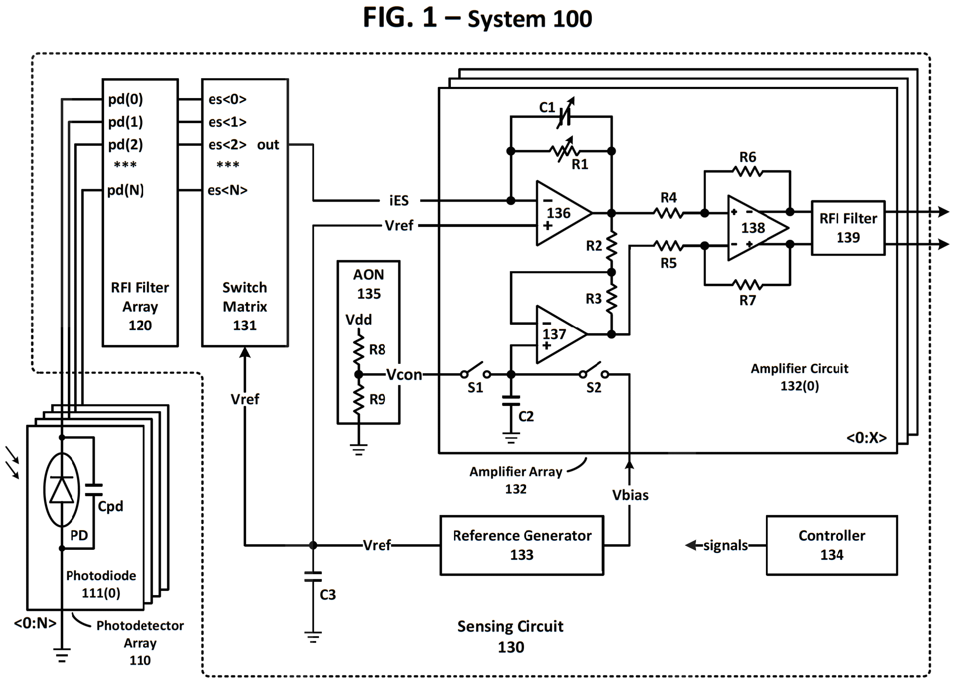

FIG. 1 illustrates a system 100 for sensing light. In operation, the system 100 may utilize a pre-charging technique to mitigate dielectric absorption in both on-chip and off-chip capacitors. The strategic placement and values of these capacitors and resistors may work together to optimize the performance of the system 100, particularly in managing noise, setting appropriate bias points, and mitigating dielectric absorption in various parts of the circuit. The system 100 may include a photodetector array 110, a radio frequency interference (RFI) filter array 120, and a sensing circuit 130. Those skilled in the art will appreciate there may be additional components in the system 100.

The system 100 may operate by receiving light at the photodetector array 110, which may generate corresponding electrical signals es<0> to es<N>. These electrical signals es<0> to es<N> may then be routed to the sensing circuit 130 for further processing and analysis. When processed, the electrical signals es<0> to es<N> may provide information about the intensity, wavelength, or other characteristics of the detected light.

The system 100 may be implemented in various applications and configurations. For instance, the system 100 may be implemented as a high-resolution image sensor for digital cameras or smartphone cameras. The system 100 may be utilized as a light detection and ranging (LiDAR) system for autonomous vehicles or robotics. The system 100 may function as an optical communication receiver for fiber-optic networks. The system 100 may be employed as a spectroscopy system for chemical analysis or material identification. The system 100 may serve as a medical imaging device, such as a digital X-ray detector or endoscope camera. The system 100 may operate as an industrial machine vision system for quality control and inspection. The system 100 may be utilized as a scientific instrument for astronomical observations or particle physics experiments. The system 100 may function as a biometric authentication system using iris or retina scanning. The system 100 may be implemented as an environmental monitoring system for detecting air quality or pollution levels. The system 100 may serve as a gesture recognition system for human-computer interaction. The system 100 may operate as a night vision device for security or military applications. The system 100 may function as a barcode or QR code scanner for inventory management or retail applications. The system 100 may be employed as a document scanner for digitizing printed materials. The system 100 may be utilized as a motion detection system for security cameras or automated lighting control. The system 100 may serve as a fluorescence microscopy system for biological research.

In each of these examples, the system 100 may be adapted and optimized for the specific requirements of the application, such as sensitivity, speed, power consumption, and environmental conditions.

FIG. 1 illustrates a system 100 that includes a photodetector array 110. The photodetector array 110 may serve an integral role in numerous fields, including optical communications, imaging systems, and environmental sensing. In some implementations, the photodetector array 110 may detect and measure light intensity across different spatial regions, enabling applications in imaging, spectroscopy, and various sensing technologies. In some implementations, the photodetector array 110 may be a fiber-optic receiver.

The photodetector array 110 may comprise a plurality of photodiodes 111(0)-111(N). The number "N" is an integer number. Any one of the photodiodes 111(0)-111(N) may be individually referred to herein as "photodiode 111." A plurality of the photodiodes 111(0)-111(N) may be collectively referred to herein as "photodiodes 111."

Each photodiode 111 may detect light and convert the detected light into one of the electrical signals es<0> to es<N>. Any one of the electrical signals es<0> to es<N> may be individually referred to herein as "electrical signal." A plurality of the electrical signals es<0> to es<N> may be collectively referred to herein as "electrical signals."

A plurality of photodiode 111 may be arranged in a matrix configuration, with outputs routed through the switch matrix 131 to the amplifier array 132 for signal processing. This modular approach may allow for scalable and flexible photodiode systems suitable for various applications, including imaging, light detection, and optical communication. Those skilled in the art will appreciate there may be additional components in a photodiode 111.

A photodiode 111 may include light-sensitive device (PD) that detects light intensity and generates a photodiode signal (e.g., any of the photodiode signals pd(k+0)-pd(N)) proportional to the incident light intensity. In such cases, the light-sensitive device (PD) may convert incident light into the photodiode signal through the photoelectric effect. For instance, when photons strike semiconductor material of the light-sensitive device (PD), the light-sensitive device (PD) may generate electron-hole pairs, resulting in the electrical signal proportional to the light intensity. This process may involve the absorption of photons by the semiconductor material of the photodiode 111, which may create electron-hole pairs.

The photodiode 111 may detect light across various wavelengths, depending on the specific application requirements. In some cases, different photodiodes 111 within the photodetector array 110 are optimized for different wavelengths of light. The arrangement of multiple photodiode 111 in the photodetector array 110 may allow for simultaneous light detection at multiple points, providing spatial resolution and enabling the capture of detailed light distribution information.

A photodiode 111 may also include parasitic capacitance Cpd. This parasitic capacitance Cpd may arise from the inherent physical structure of the light-sensitive device (PD), particularly at the p-n junction. Parasitic capacitance Cpd can affect the frequency response and noise characteristics of the light-sensitive device (PD).

The photodetector array 110 is electrically connected to the RFI filter array 120.

The sensing circuit 130 may be found in various types of electrically powered devices. For example, the sensing circuit 130 may be found in a mobile communication device such as a mobile phone, smartphone, cell phone, or tablet. The sensing circuit 130 may be found in a wearable device, smartwatch, fitness tracker or personal digital assistant. The sensing circuit 130 may be found in a media device for playing and/or recording media. For instance, the sensing circuit 130 may include a portable music player, audio recorder, audio converter, audio player, or speaker (e.g., a Bluetooth-enabled speaker). The sensing circuit 130 may be found in video devices such as a video display, video recorder, camera, or other video device. The sensing circuit 130 may be found in a driver assistance module in a vehicle, a light detection and ranging sensor, an emergency transponder, a pager, a watch, a satellite television receiver, a stereo receiver, a computer system, music player, laptop or tablet computer, home appliance, or various other devices. The sensing circuit 130 may be found in a computing/entertainment device for a vehicle.

The sensing circuit 130 may include components that work together to process electrical signals from the photodetector array 110 and help mitigate dielectric absorption. For instance, the sensing circuit 130 may include a switch matrix 131, an amplifier array 132, a reference generator 133, a controller 134, and an always-on (AON) voltage source 135. Those skilled in the art will appreciate there may be additional components in sensing circuit 130.

The switch matrix 131 serves as a crucial intermediary component between the photodetector array 110 and the sensing circuit 130, facilitating controlled signal routing and management. This matrix enables selective connectivity between individual photodiodes 111 and the amplifier circuits 132, allowing for precise control over which photodiodes are active at any given time.

By regulating the signal flow, the switch matrix 131 plays a vital role in a sequence of states, including sleep, pre-charge, and active states. For example, when operational, the switch matrix 131 may receive the electrical signals es<0> to es<N> from the RFI filter array 120 in response to incident light. These electrical signals es<0> to es<N> may represent the photocurrent produced by each photodiode 111. The switch matrix 131 then routes these electrical signals es<0> to es<N> to an appropriate amplifier circuit 132 within the amplifier array 132 as a single electrical signal (iES) for further processing.

The flexibility provided by the switch matrix 131 enables efficient power management and optimized performance of the sensing circuit 130. It allows for selective activation of photodiodes, implementation of various scanning patterns, and adaptation to different sensing requirements, making it a key component in the overall functionality and versatility of the photodiode sensing system.

The amplifier array 132 may amplify and condition the electrical signals received from the light-sensitive devices (PD). On such occasions, the amplifier array 132 may process the electrical signal (iES) from the switch matrix 131 and a reference voltage (Vref) from a reference generator 133.

A reference generator 133 may produce reference voltages that are stable and unvarying. These reference voltages may include a reference voltage (Vref) and a bias voltage (Vbias). Despite any fluctuation of any loading condition produced by the sensing circuit 130, the reference generator 133 may maintain the reference voltage (Vref) at one voltage level while simultaneously maintaining the bias voltage (Vbias) at another voltage level. The amplifier array 132 may receive the reference voltage (Vref) and the bias voltage (Vbias).

The sensing circuit 130 may also include a filter capacitor C3. In some cases, the filter capacitor C3 may be implemented as a metal-oxide-metal (MOM) capacitor with a metal box shield to mitigate coupling. In some implementations, the filter capacitor C3 may be a capacitor that is external to the sensing circuit 130. The filter capacitor C3 may have a ground connection directly to a bump for minimal ground impedance. This configuration may help reduce noise and improve the overall performance of the reference generator 133.

The sensing circuit 130 may include an AON voltage source 135. The AON voltage source 135 may provide a constant voltage (Vcon) to ISO capacitor C2 when reference generator 133 is in low power or sleep state.

Controller 134 is electronic hardware implemented as any suitable processing circuitry. The processing circuitry may include, but not limited to, at least one of a microcontroller, a microprocessor, a single processor, and a multiprocessor. Controller 134 may include at least one of an embedded controller (EC), a central processing unit (CPU), an accelerated processing unit (APU), an application specific integrated circuit (ASIC), field programmable gate arrays (FPGA), control logic, a state machine, programmable processor, or the like. Controller 134 may be implemented as electronic hardware that may include digital circuits, analog circuits or a combination of both digital and analog circuits. Analog circuits may include analog components that are suitable to process analog gate signals. Digital circuits may include switches and gates that are suitable to process digital gate signals. The controller 134 may employ digital counters, phase-locked loops, or other clock management techniques to derive the required timing signals from a master clock source. As will be explained in detail, controller 134 may control the functions and circuitry of the system 100.

The amplifier array 132 may comprise a plurality of amplifier circuits 132(0)-132(X) arranged in a specific configuration. The number "X" is an integer number. Any one of the amplifier circuits 132(0)-132(X) may be individually referred to herein as "amplifier circuit 132." Amplifier circuits 132(0)-132(X) may be collectively referred to herein as "amplifier circuits 132."

For processing the electrical signals received through the switch matrix 131, an amplifier circuit 132 may include multiple amplifier components such as feedback capacitor C1, switches S1-S2, resistors R1-R7, a transimpedance amplifier (TIA) 136, an isolation (ISO) buffer 137, a differential amplifier 138, and an RFI filter 139. Those skilled in the art will appreciate there may be additional components in the amplifier circuit 132.

The TIA amplifier 136 may receive a reference voltage (Vref) from the reference generator 133 at the non-inverting input of the TIA amplifier 136 and electrical signal (iES) from a photodiode 111 at the non-inverting input of the TIA amplifier 136. The TIA amplifier 136 may convert an electrical signal (iES) from the photodiode 111 into an analog voltage. This analog voltage is proportional to electrical signal (iES) according to the value of the feedback resistor R1.

The reference voltage (Vref) in the TIA amplifier 136 may play a crucial role in setting the bias voltage (Vbias) for the photodiode 111, which may directly impact the photodiode 111 performance. The photodiode 111 may operate in either photovoltaic mode (zero bias) or photoconductive mode (reverse bias), with photoconductive mode being preferred for high-speed applications due to faster response time and lower junction capacitance. In a common anode configuration, the anode of the photodiode 111 may be tied to a fixed voltage, such as ground (0V), while the cathode may connect to the inverting input of the TIA amplifier 136. The reference voltage (Vref) at this node may ensure that the photodiode 111 remains in reverse bias, allowing the photodiode 111 to respond more quickly to changes in incident light. Setting the reference voltage (Vref) to 0V in this configuration may result in the anode of the photodiode 111 being grounded, while the cathode of the photodiode 111 may be pulled to a negative voltage by the feedback action of the TIA amplifier 136, maintaining the necessary reverse bias. The switch matrix 131 may implement this setup in fiber-optic receivers and other high-speed optical detection systems, where fast signal conversion may be critical. By properly setting the reference voltage (Vref), the TIA amplifier 136 may optimize the response of a photodiode 111, ensuring efficient conversion of light into one of the electrical signals es<0> to es<N> with minimal distortion and maximum sensitivity.

In some implementations, the TIA amplifier 136 may include a feedback network comprising the feedback resistor R1 and the feedback capacitor C1. These feedback elements play a crucial role in determining the performance characteristics of the TIA amplifier 136. For instance, to control gain, bandwidth, and stability, the TIA amplifier 136 may include feedback elements such as the feedback capacitor C1 and the feedback resistor R1. The feedback capacitor C1 may work in conjunction with a feedback resistor R1 to set the gain and bandwidth characteristics of the TIA amplifier 136. This feedback arrangement may help stabilize the TIA amplifier 136, setting the gain characteristics of the TIA amplifier 136. This feedback arrangement may also allow the TIA amplifier 136 to efficiently amplify the electrical signal while maintaining signal integrity.

As used herein, the term "optimize" refers to the process of adjusting or configuring components or parameters of the sensing circuit 130 to achieve improved performance characteristics. As used herein, the term "performance characteristics" refers to measurable attributes of the sensing circuit 130. These performance characteristics may include signal-to-noise ratio, bandwidth, transimpedance gain, settling time, linearity, and dynamic range. To optimize the performance characteristics of the TIA amplifier 136, the controller 134 may adjust the feedback resistor R1 and the feedback capacitor C1. For instance, the controller 134 may adjust circuit elements such as feedback resistor R1, feedback capacitor C1, or other adjustable components to enhance sensitivity, dynamic range, noise reduction, or settling time.

Feedback capacitor C1 is an electronic component whose capacitance can be adjusted or varied dynamically. This adjustment may be achieved through various means, such as mechanical manipulation, electronic control by a signal from the controller 134, or in response to external stimuli like voltage or temperature. Feedback capacitor C1 may play a crucial role in tuning circuit characteristics of the amplifier circuit 132, such as frequency response or impedance matching by the amplifier circuit 132.

The term "capacitance adjustment" may refer to the process of altering the capacitance value of a feedback capacitor C1. The controller 134 may perform this adjustment automatically. In some implementations, this adjustment may be performed manually by an external user or system. The ability to adjust capacitance may allow for fine-tuning of circuit parameters, such as bandwidth, resonance frequency, or phase compensation.

"Dynamic range enhancement" may refer to the process of modifying circuit parameters, including the feedback capacitor C1, to maximize the range of input signals that can be accurately processed by the TIA amplifier 136. This dynamic range enhancement may involve adjusting the capacitance of the feedback capacitor C1 to optimize the frequency response of the TIA amplifier 136 or to compensate for parasitic capacitance (Cpd) in the photodetector array 110, thereby improving overall performance and sensitivity of the sensing circuit 130.

As used herein, the term "transimpedance" refers to the ratio of output voltage to input current in the TIA amplifier 136, typically expressed in units of ohms (Ω). The transimpedance is primarily determined by the value of the feedback resistor R1 and defines the current-to-voltage conversion factor of the TIA amplifier 136. In the sensing circuit 130, the transimpedance directly influences the amplification of the electrical signals (iES) generated by the photodiodes 111.

Feedback resistor R1 is an electrical component or circuit element whose resistance can be adjusted or changed dynamically. This adjustment may be achieved through various means, such as mechanical manipulation, electronic control by a signal from the controller 134, or in response to external stimuli like light, temperature, or applied voltage. Feedback resistor R1 may play a crucial role in optimizing the performance of the TIA amplifier 136 or other components within the sensing circuit 130. For example, the feedback resistor R1 may set the gain of the TIA amplifier 136.

The term "resistance adjustment" may refer to the process of altering the resistance value of the feedback resistor R1. This adjustment may be performed automatically by the controller 134, or manually by an external user or system. The ability to alter the resistance value of the feedback resistor R1 may allow for fine-tuning of circuit characteristics, such as gain, bandwidth, or noise performance of TIA amplifier 136, in response to changing operating conditions or requirements.

The term, "dynamic range optimization" may refer to the process of modifying circuit parameters, including the feedback capacitor C1 and/or the feedback resistor R1, to maximize the range of input signals that can be accurately processed by the TIA amplifier 136. This optimization may involve an adjustment to the feedback capacitor C1 and/or the feedback resistor R1 by controller 134 to accommodate varying levels of ambient light and signal strength, thereby improving the overall performance and sensitivity of the TIA amplifier 136.

The term "discrete digital representations" may refer to quantized numerical values that represent sampled analog signals in a digital format. These representations may consist of a finite set of possible values, typically expressed as binary numbers, which approximate the continuous analog signal at specific points in time. The process of converting an analog signal to discrete digital representations may involve sampling the analog signal at regular intervals and quantizing the sampled values to the nearest available digital level.

The term "digital representations" may refer to information encoded in a binary format using a finite set of discrete values, typically represented as bits (0s and 1s). These representations may describe various types of data including, but not limited to, sampled analog signals, text, images, or numerical values. In the context of signal processing, digital representations may allow for the manipulation, storage, and transmission of information using digital systems and algorithms. The resolution and accuracy of these discrete digital representations may depend on factors such as the sampling rate and the number of bits used to represent each sample.

The differential amplifier 138 may amplify the difference between the output of the TIA amplifier 136 and the output of the ISO buffer 137.

The amplifier circuit 132 may employ a voltage divider network composed of resistors R2 and R3 to establish the bias voltage (Vbias) from the reference generator 133 and/or the constant voltage (Vcon) from the always-on (AON) voltage source 135. This configuration may enable precise control of the operating point for an amplifier circuit 132.

The reference generator 133 may provide a stable, temperature-compensated voltage reference, while the AON voltage source 135 may ensure continuous availability of a bias voltage, even when other parts of the circuit are powered down. By utilizing both the reference generator 133 and the AON voltage source 135, the sensing circuit 130 may maintain stable bias conditions during the sequence of states.

The ISO buffer 137, a key component in the signal processing chain, may perform multiple functions. For example, the ISO buffer 137 serves multiple important functions within the amplifier circuit 132.

Firstly, the ISO buffer 137 may invert the output signal from the TIA amplifier 136 using the resistor network composed of R2 and R3. This signal inversion is critical for maintaining the proper phase relationship between various signals within the amplifier circuit 132. By inverting the TIA output, the ISO buffer 137 ensures that subsequent stages of the circuit, particularly the differential amplifier 138, receive signals with the correct polarity and timing relationships. This inversion helps preserve the integrity of the original photodetector signal throughout the signal processing chain.

Additionally, the ISO buffer 137 may provide isolation between the TIA amplifier 136 and subsequent stages, helping to prevent loading effects that could otherwise distort the TIA output. This isolation function is particularly important in high-sensitivity applications where maintaining signal fidelity is crucial. The resistor network R2 and R3 not only facilitates the inversion but also helps set the DC operating point for the ISO buffer 137, ensuring it operates within its linear range for optimal performance.

The ISO buffer 137 may level-shift the output using the bias voltage (Vbias), which may help to optimize the signal range for subsequent processing stages. The output of the ISO buffer 137 may serve as the complementary input to the differential amplifier 138. This complementary input arrangement may be essential for implementing a differential amplifier configuration, which may offer improved noise rejection and increased dynamic range compared to single-ended amplifier designs. Furthermore, the ISO buffer 137 may facilitate a gain and a common-mode shift at the output of the differential amplifier 138. In some implementations, the gain is a 2x gain. The gain may double the signal amplitude, enhancing the signal-to-noise ratio for weak electrical signals (iES). The common-mode shift may adjust the DC level of the output signal, which may be critical for increasing the overall dynamic range of the amplifier circuit 132. This expanded dynamic range may allow the amplifier circuit 132 to accurately process a wider range of amplitudes in the electrical signals (iES).

The resistor R4 and the resistor R5 may be connected to the inputs of the differential amplifier 138, while the resistor R6 and the resistor R7 may provide feedback paths. Resistors R4, R5 may help set the gain and input impedance characteristics of the differential amplifier 138. Resistors R6, R7 may provide feedback paths in the differential amplifier 138. These feedback resistors R6, R7 may help control the overall gain and stability of the differential amplifier 138.

After the differential amplifier 138, the signal path in the amplifier circuit 132. The RFI filter 139 may attenuate high-frequency noise and interference that could affect the accuracy of the sensing circuit 130.

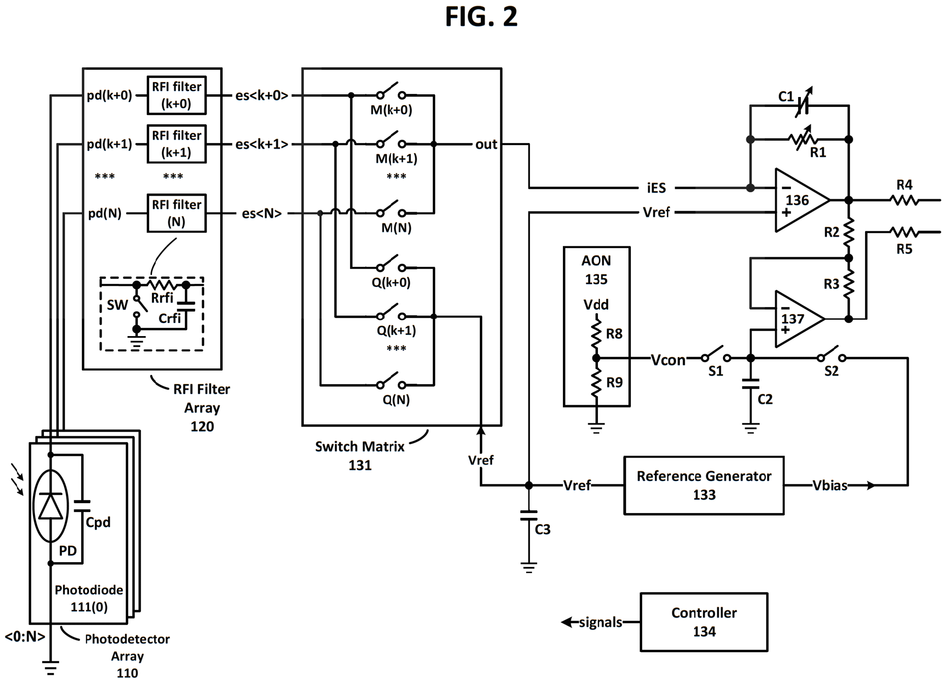

FIG. 2 illustrates a photodiode 111, switch matrix 131, amplifier circuit 132, reference generator 133 and controller 134. Photodiode 111 may happen to be any one of the photodiodes 111(0)-111(N) of FIG. 1. Amplifier circuit 132 may happen to be any one of the amplifier circuit 132(0)-132(X) of FIG. 1.

Switch matrix 131 may include switches M(k+0)-M(N) and switches Q(k+0)-Q(N). The photodiode signals pd(k+0)-pd(N) may happen to be signals to and from the photodiodes 111. The electrical signals es<k+0> to es<N>, may happen to be signals to and from the RFI filter array 120. Switches M(k+0)-M(N) may electrically connect the non-inverting input of the TIA amplifier 136 to any of the electrical signals es<k+0> to es<N>, respectively. The number "k" is an integer number.

As illustrated in FIG. 2, each of the RFI filters (k+0) to (N) may include a switch SW, a resistor Rrfi and a capacitor Crfi. The switch SW may allow the RFI filter to be selectively connected or disconnected to ground. The resistor Rrfi and the capacitor Crfi are arranged in a low-pass filter configuration to reduce high-frequency noise that may interfere with the operation of the photodiodes 111. This low-pass filter may attenuate unwanted high-frequency signals while allowing the desired lower-frequency electrical signal to pass through.

Any one of the RFI filters (k+0) to (N) may be individually referred to herein as an "RFI filter." A plurality of the RFI filters (k+0) to (N) may be collectively referred to herein as "RFI filters." The RFI filter may be useful in environments with electromagnetic interference or when dealing with high-speed optical signals, as the filter may help maintain the integrity of the detected signal.

Positioned between the switch matrix 131 and the photodetector array 110, the RFI filters may reduce electromagnetic noise and improve the signal-to-noise ratio of the electrical signals es<0> to es<N> before the TIA amplifier 136 processes electrical signals es<0> to es<N>.

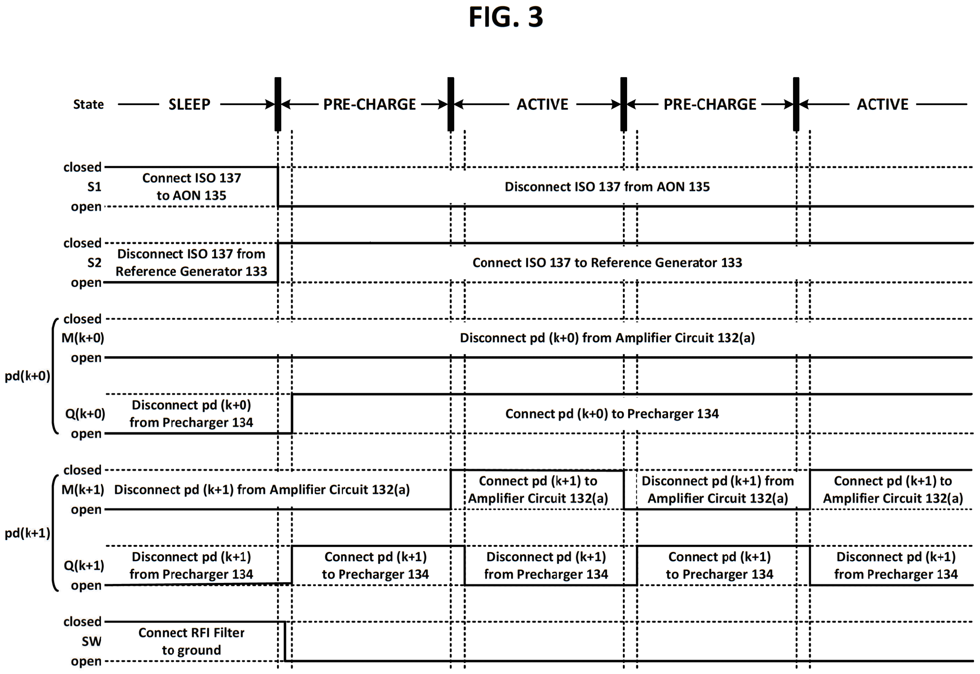

Turning now to FIG. 3, a sequence of states is illustrated. The controller 134 may manage the sequence of states. The sequence may include a sleep state, a pre-charge state and an active state. Those skilled in the art will appreciate that additional states may be included.

Dielectric absorption may cause a capacitor to retain residual charge even after discharge, leading to measurement inaccuracies. As used herein, the term "dielectric absorption" refers to the phenomenon in capacitors where a residual charge remains or slowly redistributes after the capacitor has been discharged. This phenomenon occurs when the capacitor does not fully release its stored charge, resulting in extended settling times and potential errors in signal processing. Dielectric absorption may cause particular problems in high-precision analog circuits where the TIA amplifier 136 and differential amplifier 138 require signal accuracy and stability for proper operation. For instance, dielectric absorption may manifest in the system 100 as slow settling times, measurement inaccuracies, and non-linear responses.

As used herein, the term "mitigating" refers to the process of reducing, minimizing, or counteracting the effects of dielectric absorption in capacitive elements of the system 100. Mitigating involves implementing techniques or circuit configurations that lessen the influence of residual charge accumulation and slow charge redistribution associated with dielectric absorption in the photodiodes 111, the feedback capacitor C1, the ISO capacitor C2, and the capacitors Crfi. From the reference generator 133, the reference voltage (Vref) and the bias voltage (Vbias) may mitigate dielectric absorption in the photodiodes 111, the feedback capacitor C1, the ISO capacitor C2, and the capacitors Crfi.

The controller 134 may control the switching between the sequence of states in FIG. 3 to mitigate the dielectric absorption in the capacitor Crfi in the RFI filters, parasitic capacitance Cpd in the photodiodes 111, and in the feedback capacitor C1 and ISO capacitor C2 of the amplifier circuits 132. By way of example, the controller 134 may control the opening and closure of switches S1-S2, switches M(k+0)-M(N), switches Q(k+0)-Q(N), and switch SW to mitigate the dielectric absorption. FIG. 3 illustrates the terms "open" and "closed" as status indicators for the switches. These status indicators may provide information about the state of each switch at different points in the sequence of states. When a switch is "open," the switch may be non-conductive, effectively breaking the electrical connection between the switch terminals. When a switch is "closed," the switch may be conductive, allowing current to flow through the switch.

To coordinate the sequence of states across the sleep, pre-charge, and active states of the sensing circuit 130, the controller 134 may control the status of switches S1-S2, switches M(k+0)-M(N), switches Q(k+0)-Q(N), and switch SW. The controller 134 may implement dielectric absorption mitigation through specific switching sequences and timing control. As an illustration in the example of FIG. 3, the photodiode 111 associated with switches M(k+0) and Q(k+0) may happen to be deactivated during the sleep state, the pre-charge state and the active state. Under such circumstances, the controller 134 may control switch M(k+0) to remain open so as to disconnect the photodiode 111 (k+0) from TIA amplifier 136 in the amplifier circuit 132 during the entire sequence.

The controller 134 may control the switches in the manner illustrated in the example of FIG. 3 to place the sensing circuit 130 in the sleep state, the pre-charge state and the active state. During the pre-charge state, the controller 134 may control the switch matrix 131 to route the reference voltage (Vref) from the reference generator 133 to specific photodiodes 111 and the RFI filters, allowing for the settlement of dielectric absorption before active sensing begins. The switch matrix 131 having the capability to route the reference voltage (Vref) is essential for implementing the pre-charging technique used to mitigate dielectric absorption. Subsequently, in the active state, the controller 134 may reconfigure the switch matrix 131 to route the electrical signal es<0> to es<N> to the amplifier array 132 for signal amplification and processing.

As used herein, the term "sleep state" refers to a low-power operational state of the sensing circuit 130 in which components are deactivated or placed in a reduced power consumption state. The sleep state serves to conserve power when the sensing circuit 130 is not actively measuring light, while allowing for rapid transition to active sensing when needed. The controller 134 may control the power-down sequence to conserve energy while the sensing circuit 130 operates in the sleep state. The sleep state may allow the sensing circuit 130 to reduce power consumption while maintaining minimal functionality.

During the sleep state, the controller 134 may deactivate the reference generator 133. The reference generator 133 may cease producing the reference voltage (Vref) and the bias voltage (Vbias) when deactivated. The always-on (AON) voltage source 135 may provide a constant voltage (Vcon) during the sleep state. Along with powering-down the reference generator 133, the controller 134 may control the switch S1 to connect the ISO buffer 137 to the AON voltage source 135 while simultaneously controlling the switch S2 to disconnect the ISO buffer 137 from the reference generator 133 during the sleep state. The bias voltage (Vbias) is disconnected from the ISO capacitor C2 while the AON voltage source 135 may provide a constant voltage (Vcon) to pre-charge the ISO capacitor C2 in order to mitigate dielectric absorption in the ISO capacitor C2.

The absence of reference voltage (Vref) during the sleep state may directly affect the operational capability of the reference generator 133 during the sleep state. Under these conditions, the reference generator 133 may become inactive due to the absence of the reference voltage (Vref) and may not output the reference voltage (Vref). The controller 134 may control switch Q(k+0) and Q(k+1) to remain open so as to disconnect photodiode 111 (k+0) and photodiode 111 (k+1) from reference generator 133, respectively.

Also during the sleep state, the controller 134 may control switch SW in each of the photodiodes 111(0)-111(N) to become conductive while controlling switch M(k+1) to remain open so as to disconnect the photodiode 111 (k+1) from TIA amplifier 136 in the amplifier circuit 132.

To place the sensing circuit 130 in the pre-charge state, the controller 134 may activate the reference generator 133. During pre-charge state the controller 134 may control the switch S1 to disconnect the ISO buffer 137 from the AON voltage source 135 while also controlling the switch S2 to connect the ISO buffer 137 to the reference generator 133.

When activated, the reference generator 133 may produce the reference voltage (Vref) and the bias voltage (Vbias), while the amplifier circuits 132 remains disconnected from the photodiodes 111. By way of example, the controller 134 may control switch SW in each of the photodiodes 111(0)-111(N) to open while placing the sensing circuit 130 in the pre-charge state. The controller 134 may control switch M(k+1) to remain open so as to disconnect the photodiode 111 (k+1) from TIA amplifier 136 in the amplifier circuit 132 while the sensing circuit 130 is in the pre-charge state.

As used herein, the term "pre-charge state" refers to an operational state of the sensing circuit 130 that occurs between the sleep state and the active state. The controller 134 may manage the timing of this pre-charging state. This pre-charge state is crucial for improving the accuracy and settling time of subsequent measurements by addressing dielectric absorption in the sensing circuit 130.

A key innovation in the sensing circuit 130 is the reference generator 133, which implements a pre-charging technique to mitigate dielectric absorption in both the parasitic capacitance Cpd found in a photodiode 111 and the capacitor Crfi in an RFI filter. As used herein, the term "pre-charging technique" refers to a process employed by the sensing circuit 130 to mitigate dielectric absorption due to the parasitic capacitance Cpd in the photodiodes 111. This pre-charging technique involves applying a reference voltage (Vref) to at least one photodiode 111 and its associated parasitic capacitance Cpd for a specific duration before transitioning to an active state.

The pre-charging technique is implemented during a dedicated pre-charge state, controlled by the controller 134, and utilizes a reference generator 133 to apply the reference voltage (Vref). The pre-charging technique aims to improve the accuracy and settling time of subsequent measurements by allowing dielectric absorption to settle prior to active signal sensing or amplification.

The reference generator 133 plays a crucial role in mitigating dielectric absorption across various capacitive elements within the sensing circuit 130 during the pre-charge state. This mitigation process involves applying a reference voltage (Vref) to multiple components, including at least one photodiode 111 and its associated capacitors, both integrated on-chip and external off-chip capacitors. For instance, the reference generator 133 may produce the reference voltage (Vref) and the bias voltage (Vbias) when powered up.

To facilitate the pre-charge state, the controller 134 may orchestrate a precise switching sequence, manipulating switches Q(k+0)-Q(N) to establish electrical connections between the reference generator 133 and the photodiodes 111 through their respective radio frequency interference (RFI) filters (k+0) to (k+1). This controlled routing enables the reference voltage (Vref) to reach critical capacitive elements, specifically the parasitic capacitance Cpd inherent in the photodiodes 111 and the capacitor Crfi within the RFI filters.

The application of the reference voltage (Vref) to these capacitive components serves a vital purpose: it allows the dielectric absorption to settle before an amplifier circuit 132 begins processing the electrical signal (iES) received from the switch matrix 131. This settling period is essential for improving the accuracy and stability of subsequent measurements.

Dielectric absorption, a phenomenon where capacitors retain a residual charge even after being discharged, can introduce errors and extended settling times in high-precision analog circuits. By implementing this pre-charging technique, the sensing circuit 130 effectively addresses these potential issues. The pre-charge state, controlled by the reference generator 133 and orchestrated by the controller 134, ensures that the capacitive elements reach a stable state before transitioning to the active sensing mode.

As used herein, the term "dielectric absorption to settle" refers to the process by which the residual charge in a capacitor, caused by dielectric absorption, reaches a stable state after the application of a reference voltage (Vref). This settlement occurs during the pre-charge state, where the reference generator 133 applies a reference voltage (Vref) to capacitors associated with photodiodes 111 for a specific duration. The settling process allows the molecular dipoles in the dielectric material to align with the applied electric field, reducing the impact of dielectric absorption on subsequent measurements. By allowing the dielectric absorption to settle before transitioning to the active state, the sensing circuit 130 may achieve improved accuracy and reduced settling times during active light sensing and signal amplification operations.

In the pre-charge state, the controller 134 may control switch Q(k+0) and Q(k+1) to close so as to connect photodiode 111 (k+0) and photodiode 111 (k+1) to reference generator 133, respectively. In some implementation, the controller 134 may control switch SW in each of the photodiodes 111(0)-111(N) to become non-conductive after controlling the switch S1 to disconnect the ISO buffer 137 from the AON voltage source 135 and controlling the switch S2 to connect the ISO buffer 137 to the reference generator 133. Additionally, the controller 134 may control switch Q(k+0) and Q(k+1) to close after controlling switch SW in each of the photodiodes 111(0)-111(N) to open.

The pre-charging state allows the dielectric absorption to settle in the capacitive elements, thereby improving measurement accuracy and reducing settling times when the sensing circuit 130 enters the active state. To ensure proper pre-charging of the parasitic capacitance Cpd in the photodiodes 111 and the capacitor Crfi in the RFI filters before transitioning to the active state, the controller 134 may control the duration of the pre-charge state and may manage the switching sequence of the switches M(k+0) to M(k+N) and the switches Q(k+0) to Q(k+N) as illustrated in the example of FIG. 3. Under such circumstances, the reference generator 133 may apply the reference voltage Vref to capacitive elements, including parasitic capacitance Cpd in photodiodes 111 and capacitor Crfi in RFI filters, for a controlled duration before the controller 134 transitions to the active state. This comprehensive approach to mitigating dielectric absorption demonstrates the sophisticated design of the sensing circuit 130, which considers both on-chip and off-chip capacitive elements. By addressing these effects across various components, the sensing circuit 130 aims to enhance overall measurement accuracy and reduce settling times in subsequent active light sensing and signal amplification operations.

As used herein, the term "active state" refers to a mode of the sensing circuit 130 in which a photodiode 111 detects light intensity and generates an electrical signal es<0> to es<N> proportional to the incident light intensity and the amplifier array 132 processes the electrical signal (iES). During the active state, the photodiodes 111 in the photodetector array 110 are connected to an amplifier circuit 132 through the switch matrix 131. The reference generator 133 provides the necessary reference voltages, and the TIA amplifier 136 amplifies the electrical signals generated by the photodiodes 111. The reference generator 133 may happen to be inactive during the active state, as the pre-charging process has been completed in the preceding pre-charge state. The controller 134 may manage the duration of the active state and control the switching sequence to ensure proper signal routing and amplification. The active state may represent the primary functional mode of the sensing circuit 130, where accurate light measurements are made after mitigating dielectric absorption through the pre-charging technique.

To place the sensing circuit 130 in the active state, the controller 134 may control the switch S1 so that the ISO buffer 137 remains disconnected from the AON voltage source 135 while also controlling the switch S2 so that the ISO buffer 137 remains connected to the reference generator 133. The controller 134 may control switch M(k+1) to close so as to connect the photodiode 111 (k+1) to TIA amplifier 136 in the amplifier circuit 132. To place the sensing circuit 130 in the active state, the controller 134 may control switch Q(k+0) and Q(k+1) to open so as to disconnect photodiode 111 (k+0) and photodiode 111 (k+1) from the reference generator 133, respectively. The controller 134 may control switch SW in each of the photodiodes 111(0)-111(N) to remain open while placing the sensing circuit 130 in the active state. In some implementation, the controller 134 may control switch Q(k+0) and Q(k+1) to open after controlling switch M(k+1) to close.

The timing and sequence of switches S1-S2, switches M(k+0)-M(N), switches Q(k+0)-Q(N), and switch SW may be useful for the proper functioning of the pre-charging technique and overall operation of the sensing circuit 130. By controlling the opening and closing of these switches, the controller 134 may manage signal routing, isolate different sections of the system100, and implement the pre-charging sequence to mitigate dielectric absorption. Specifically, the controller 134 may trigger timing and sequence of switches S1-S2, switches M(k+0)-M(N), switches Q(k+0)-Q(N), and switch SW to mitigate dielectric absorption in the photodiodes 111 and the RFI filter array 120 and the sensing circuit 130.

The arrangement or interconnection of components, as indicated by terms such as "coupled," "connected," "on," or "under," may allow for indirect connections or the presence of intervening components or layers. In contrast, terms such as "electrically connected directly," "electrically directly connected," and "directly electrically connected" refer specifically to connections along a conductive path without any intermediary component.

Certain operations of methods described in this technology, or systems executing those methods, may be schematically represented in figures or textual descriptions. Unless explicitly stated, the spatial arrangement of operations in figures does not necessarily dictate the sequence in which they must be performed. Operations may be executed in a different order than illustrated, depending on implementation requirements. Additionally, certain operations may be performed in parallel or partially in parallel, utilizing dedicated parallel processing devices or separate computing systems that interoperate within a larger system.

The term "or," unless otherwise defined or limited, denotes a non-exclusive list, allowing various combinations of listed elements rather than restricting them to mutually exclusive alternatives. For example, a list including "A, B, or C" may encompass A alone, B alone, C alone, any combination of two elements, or all three elements together. Exclusivity applies only when expressly stated using terms such as "either," "only one of," or "exactly one of." Similarly, lists preceded by phrases such as "one or more of" or "at least one of" indicate the possibility of multiple occurrences of any or all listed elements. A list introduced by "a plurality of" or "two or more of" suggests multiple instances of any or all elements. The term "or" should only be interpreted as exclusive when explicitly specified by contextual qualifiers.

The articles "a," "an," and "the" generally encompass both singular and plural forms unless explicitly stated otherwise. The terms "comprises," "includes," and "has" indicate the presence of stated features, components, operations, or elements while not excluding additional features, components, or combinations thereof.

Throughout this document, ordinal numbers such as "first," "second," and "third" may be used to describe various elements. These terms serve solely to distinguish elements from one another rather than imply a specific sequence, hierarchy, or limitation on quantity. Ordinal numbers do not necessarily dictate an order unless explicitly modified by terms such as "before," "after," or "single." A first element is distinct from a second element, and the first element may contain multiple components or appear before or after the second element in a given arrangement. The designation of ordinal numbers may be interchangeable without altering the scope of the described examples.

Any trademarks referenced herein may be common law or registered trademarks of third parties affiliated or unaffiliated with the applicant or assignee. These references are provided for illustrative purposes only and should not be interpreted as limiting the disclosed embodiments to material associated exclusively with those trademarks.

The following are further embodiments of the invention:
1. An apparatus, comprising:
   a transimpedance amplifier configured to:
      receive a reference voltage from a reference generator, and
      receive an electrical signal from a photodetector; and
   a switch matrix configured to:
      route, prior to the transimpedance amplifier receiving the electrical signal, the reference voltage from the reference generator to the photodetector,
      route, subsequent to routing the reference voltage to the photodetector, the electrical signal from the photodetector to the transimpedance amplifier.
2. The apparatus of embodiment 1, wherein the switch matrix is configured to:
   mitigate, in response to routing the reference voltage to the photodetector, dielectric absorption in the photodetector.
3. The apparatus of embodiment 1, wherein the transimpedance amplifier comprises a feedback network including a feedback resistor and a feedback capacitor.
4. The apparatus of embodiment 3, wherein the feedback resistor is adjustable to optimize performance characteristics of the transimpedance amplifier.
5. The apparatus of embodiment 3, wherein the feedback capacitor is adjustable to optimize performance characteristics of the transimpedance amplifier.
6. The apparatus of embodiment 1, further comprising:
   a radio frequency interference (RFI) filter connected between the switch matrix and the photodetector.
7. The apparatus of embodiment 5, wherein the RFI filter is configured to route the reference voltage from the switch matrix to the photodetector.
8. The apparatus of embodiment 5, wherein the RFI filter is configured to route the electrical signal from the photodetector to the switch matrix.
9. The apparatus of embodiment 5, wherein the RFI filter comprises a resistor and a capacitor forming a low-pass filter.
10. The apparatus of embodiment 7, wherein the switch matrix is configured to:
   mitigate, in response to routing the reference voltage to the photodetector, dielectric absorption in the capacitor.
11. The apparatus of embodiment 1, further comprising:
   an isolation (ISO) buffer connected to an output of the transimpedance amplifier.
12. The apparatus of embodiment 8, wherein the ISO buffer is configured to invert the output of the transimpedance amplifier using a resistor network.
13. The apparatus of embodiment 8, further comprising:
   a differential amplifier configured to amplify a difference between an output of the transimpedance amplifier and an output of the ISO buffer.
14. The apparatus of embodiment 1, further comprising:
   an always-on (AON) voltage source configured to provide a constant voltage to a capacitor during a sleep state.
15. The apparatus of embodiment 11, further comprising a first switch configured to connect the capacitor to the AON voltage source during the sleep state and a second switch configured to connect the capacitor to the reference generator during a pre-charge state.
16. A system comprising:
   a photodetector array comprising a plurality of photodetectors, a photodetector is one of the photodetectors in the photodetector array;
   a transimpedance amplifier configured to:
      receive a reference voltage from a reference generator, and
      receive an electrical signal from the photodetector; and
   a switch matrix configured to:
      route, prior to the transimpedance amplifier receiving the electrical signal, the reference voltage from the reference generator to the photodetector,
      route, subsequent to routing the reference voltage to the photodetector, the electrical signal from the photodetector to the transimpedance amplifier.
17. The system of embodiment 12, wherein the switch matrix is configured to:
   selectively route the reference voltage to different photodetectors in the photodetector array.
18. A method, comprising:
   receiving, by a transimpedance amplifier, a reference voltage from a reference generator;
   receiving, by the transimpedance amplifier, an electrical signal from a photodetector;
   routing, by a switch matrix prior to the transimpedance amplifier receiving the electrical signal, the reference voltage from the reference generator to the photodetector; and
   routing, by the switch matrix subsequent to routing the reference voltage to the photodetector, the electrical signal from the photodetector to the transimpedance amplifier.
19. The method of embodiment 14, wherein routing the reference voltage to the photodetector prior to the transimpedance amplifier receiving the electrical signal mitigates dielectric absorption in the photodetector.
20. The method of embodiment 14, wherein:
   a radio frequency interference (RFI) filter is connected between the switch matrix and the photodetector, and
   routing the reference voltage to the photodetector prior to the transimpedance amplifier receiving the electrical signal mitigates dielectric absorption of a capacitor in the RFI filter.

## Claims

1. An apparatus, comprising:
a transimpedance amplifier configured to:
receive a reference voltage from a reference generator, and
receive an electrical signal from a photodetector; and
a switch matrix configured to:
route, prior to the transimpedance amplifier receiving the electrical signal, the reference voltage from the reference generator to the photodetector,
route, subsequent to routing the reference voltage to the photodetector, the electrical signal from the photodetector to the transimpedance amplifier.

2. The apparatus of claim 1, wherein the switch matrix is configured to:
mitigate, in response to routing the reference voltage to the photodetector, dielectric absorption in the photodetector.

3. The apparatus of claims 1 or 2, wherein the transimpedance amplifier comprises a feedback network including a feedback resistor and a feedback capacitor.

4. The apparatus of claim 3, wherein the feedback resistor is adjustable to optimize performance characteristics of the transimpedance amplifier,
and/or
wherein the feedback capacitor is adjustable to optimize performance characteristics of the transimpedance amplifier.

5. The apparatus of one of the previous claims, further comprising:
a radio frequency interference (RFI) filter connected between the switch matrix and the photodetector.

6. The apparatus of claim 5, wherein the RFI filter is configured to route the reference voltage from the switch matrix to the photodetector,
and/or
wherein the RFI filter is configured to route the electrical signal from the photodetector to the switch matrix.

7. The apparatus of claims 5 or 6, wherein the RFI filter comprises a resistor and a capacitor forming a low-pass filter,
in particular,
wherein the switch matrix is configured to:
mitigate, in response to routing the reference voltage to the photodetector, dielectric absorption in the capacitor.

8. The apparatus of one of the previous claims, further comprising:
an isolation (ISO) buffer connected to an output of the transimpedance amplifier.

9. The apparatus of claim 8, wherein the ISO buffer is configured to invert the output of the transimpedance amplifier using a resistor network.

10. The apparatus of claims 8 or 9, further comprising:
a differential amplifier configured to amplify a difference between an output of the transimpedance amplifier and an output of the ISO buffer.

11. The apparatus of one of the previous claims, further comprising:
an always-on (AON) voltage source configured to provide a constant voltage to a capacitor during a sleep state, in particular, further comprising a first switch configured to connect the capacitor to the AON voltage source during the sleep state and a second switch configured to connect the capacitor to the reference generator during a pre-charge state.

12. A system comprising:
a photodetector array comprising a plurality of photodetectors, a photodetector is one of the photodetectors in the photodetector array;
a transimpedance amplifier configured to:
receive a reference voltage from a reference generator, and
receive an electrical signal from the photodetector; and
a switch matrix configured to:
route, prior to the transimpedance amplifier receiving the electrical signal, the reference voltage from the reference generator to the photodetector,
route, subsequent to routing the reference voltage to the photodetector, the electrical signal from the photodetector to the transimpedance amplifier.

13. The system of claim 12, wherein the switch matrix is configured to:
selectively route the reference voltage to different photodetectors in the photodetector array.

14. A method, comprising:
receiving, by a transimpedance amplifier, a reference voltage from a reference generator;
receiving, by the transimpedance amplifier, an electrical signal from a photodetector;
routing, by a switch matrix prior to the transimpedance amplifier receiving the electrical signal, the reference voltage from the reference generator to the photodetector; and
routing, by the switch matrix subsequent to routing the reference voltage to the photodetector, the electrical signal from the photodetector to the transimpedance amplifier.

15. The method of claim 14, wherein routing the reference voltage to the photodetector prior to the transimpedance amplifier receiving the electrical signal mitigates dielectric absorption in the photodetector,
and/or
wherein:
a radio frequency interference (RFI) filter is connected between the switch matrix and the photodetector, and
routing the reference voltage to the photodetector prior to the transimpedance amplifier receiving the electrical signal mitigates dielectric absorption of a capacitor in the RFI filter.
